# EUROPEAN PATENT APPLICATION

(11) **EP 1 455 204 A1**
(43) Date of publication of application: **08.09.2004**
(21) Application number: 04075727.0
(22) Date of filing: 05.03.2004
(51) Int. Cl.: G02B 5/04, G02B 26/00, G03F 7/20

(54) **Device and method for manipulation and routing of a metrology beam**

(30) Priority: 06.03.2003 EP 03075659
(71) Applicant: ASML Netherlands B.V., 5503 LA Veldhoven (NL)
(72) Inventor: Van der Pasch, E. A. F., 5688 EG Oirschot (NL); Beems, M.H.M., 5508 EK Veldhoven (NL); Eussen, E.J.M., 6269 CM Margraten (NL); Klijntunte, E.J.J., 5508 WC Veldhoven (NL)
(74) Representative: van Westenbrugge, Andries

(57) **Abstract**

A lithographic projection apparatus (1) is equipped with a device (100) for manipulation and routing of at least one portion of a metrology beam (MB) of radiation. The device includes a first (2) and a second (3) optical wedge, wherein the second optical wedge and the first optical wedge having a relative position with respect to each other.

The at least one portion of the metrology beam enters the device along an incoming optical axis (OA) at a first major surface (2a) of the first optical wedge, passes through the first and second optical wedges, and exits at a second major surface (3a) of the second optical wedge.

The first and second optical wedges are arranged to at least one of rotate and translate the at least one portion of the metrology beam relative to the incoming optical axis by changing the relative position of the first and the second optical wedges.

## Description

### Field

The present invention relates to a lithographic proj ection apparatus as defined in the preamble of claim 1. Also the present invention relates to a device for manipulation and routing of at least one portion of a metrology beam of radiation as set forth in the preamble of claim 12. Furthermore, the present invention relates to a device manufacturing as set forth in the preamble of claim 14.

### Background

The present invention finds a preferred application in the field of lithographic projection apparatus that encompass a radiation system for supplying a projection beam of radiation, a support structure for supporting patterning means, which serves to pattern the projection beam according to a desired pattern, a substrate table for holding a substrate, and a projection system for projecting the patterned beam onto a target portion of the substrate.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:
- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmission mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired;
- A programmable mirror array. One example of such a device is a matrix-addressable surface having a visco-elastic control layer and a reflective surface. The basic principle behind such an apparatus is that (for example) addressed areas of the reflective surface reflect incident light as diffracted light, whereas unaddressed areas reflect incident light as non-diffracted light. Using an appropriate filter, the said non-diffracted light can be filtered out of the reflected beam, leaving only the diffracted light behind; in this manner, the beam becomes patterned according to the addressing pattern of the matrix-addressable surface. An alternative embodiment of a programmable mirror array employs a matrix arrangement of tiny mirrors, each of which can be individually tilted about an axis by applying a suitable localised electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described here above, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096, which are incorporated herein by reference. In the case of a programmable mirror array, the said support structure may be embodied as a frame or table, for example, which may be fixed or movable as required; and
- A programmable LCD array. An example of such a construction is given in United States Patent US 5,229,872, which is incorporated herein by reference. As above, the support structure in this case may be embodied as a frame or table, for example, which may be fixed or movable as required.

For purposes of simplicity, the rest of this text may, at certain locations, specifically direct itself to examples involving a mask and mask table; however, the general principles discussed in such instances should be seen in the broader context of the patterning means as set forth here above.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (e.g. comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper or step-and-repeat apparatus. In an alternative apparatus ― commonly referred to as a step-and-scan apparatus ― each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792, incorporated herein by reference.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallisation, oxidation, chemical-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4, incorporated herein by reference.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791, both incorporated herein by reference.

In lithographic projection apparatus, various interferometers (typically) share the same light source such as a laser, which produces a laser projection beam. It is to be noted that this shared laser projection beam does not relate to the projection beam as described above for the purpose of projecting a pattern of the patterning means onto a substrate. The shared laser projection beam will further be referred to herein as a metrology beam. To share the metrology beam throughout the lithographic projection apparatus, the metrology beam is routed through the apparatus to reach each interferometer. To prevent second order measurement errors and loss of range in the interferometers (and consequently causing inaccuracies in the use of the lithographic projection apparatus), it is important to accurately align (in the order of µrad) the metrology beam to the measurement object (e.g., a stage). After beam alignment, the interferometer system is calibrated. All relevant parameters (relating to angular and lateral position of the beam) are determined and are assumed to be stable in time.

Between calibrations, the stability of components for routing the metrology beam that can influence the alignment parameters (especially, beam bender manipulators) is very important. For example, if alignment parameters change during operation (e.g., due to drift), the accuracy of the lithographic projection apparatus may be affected. Therefore, the stability of the routing components is an important issue in relation to the measurement accuracy of an interferometer system.

Routing and manipulation of metrology beams is typically done by an arrangement comprising an adjustable mirror which can modify the pointing direction of a metrology beam impinging on it. Using such an adjustable mirror has a disadvantage due to the fact that rotation and/or tilt of the mirror (which two operations have an inherent instability) can lead to an inaccurate pointing of the beam. The beam alignment is thus prone to uncertainties relating to a rotation error and a tilting error.

It is an object of the present invention to provide a device for manipulation and routing of a metrology beam which has an improved stability over devices for manipulation and routing of a metrology beam from the prior art.

This object is achieved according to the invention in a lithographic projection apparatus as defined in the preamble of claim 1, characterised in that the apparatus comprises a device for manipulation and routing of at least one portion of a metrology beam of radiation, the device comprising a first and a second optical wedge, the second optical wedge and the first optical wedge having a relative position with respect to each other, the at least one portion of the metrology beam entering the device along an incoming optical axis at a first major surface of the first optical wedge, passing through the first and second optical wedges, and exiting at a second major surface of the second optical wedge, the first and second optical wedges being arranged to at least one of rotate and translate the at least one portion of the metrology beam relative to the incoming optical axis by changing the relative position of the first and the second optical wedges.

The large ratio between mechanical adjustments made in the manipulating device and their influence on the beam's angular and lateral position leads to a high adjustment resolution and a low sensitivity to mechanical changes and/or instabilities. Adjustments of the device for the alignment of the beam are done along major axes of the device, which results in an improved stability of the alignment. As an advantage, this leads to calibrations of the pointing direction which remain accurate over a longer term, before re-calibration may be necessary. Because of the long term stability of the device for manipulation and routing of a metrology beam, the accuracy improvement within a lithographic projection apparatus can be up to 2-3 nm / 3 months. Of course, the device could applied in other applications, such as machining.

Furthermore, the improved adjustment resolution can lead to a cycle time reduction during manufacturing since the adjustment can be performed in a relatively simpler and less time-consuming way than in the prior art.

The present invention also relates to a lithographic projection apparatus as defined in the preamble of claim 6 characterised in that
the apparatus comprises a device for manipulation and routing of at least one portion of a metrology beam of radiation,
the device comprising a first and a second optical wedge,
at least one of a first and second major surface of the second optical wedge being provided with a reflective coating,
the second optical wedge and the first optical wedge having a relative position with respect to each other,
the at least one portion of the metrology beam entering the device along an incoming optical axis at a first major surface of the first optical wedge, passing through the first optical wedge, entering on one of the first and second major surface of the second optical wedge and reflecting at the one of the first and second major surface of the second optical wedge,
the first and second optical wedges being arranged to at least one of rotate and translate the at least one portion of the metrology beam relative to the incoming optical axis by changing the relative position of the first and the second optical wedges.

Furthermore, the present invention relates to a device for manipulation and routing of at least one portion of a metrology beam of radiation, characterised in that the device comprises a first and a second optical wedge, the second optical wedge and the first optical wedge having a relative position with respect to each other, the at least one portion of the metrology beam entering the device along an incoming optical axis at a first major surface of the first optical wedge, passing through the first and second optical wedges, and exiting at a second major surface of the second optical wedge, the first and second optical wedges being arranged to at least one of rotate and translate the at least one portion of the metrology beam relative to the incoming optical axis by changing the relative position of the first and the second optical wedges.

According to a further aspect of the invention there is provided a device manufacturing method comprising the steps of:- providing a metrology beam of radiation using a radiation system,
characterised by
- entering at least one portion of the metrology beam along an incoming optical axis at a first major surface of a first optical wedge,
- passing the at least one portion of the metrology beam through the first optical wedge and through a second optical wedge, the second optical wedge and the first optical wedge having a relative position with respect to each other,
- exiting the at least one portion of the metrology beam at a second major surface of the second optical wedge, and
- at least one of rotating and translating the at least one portion of the metrology beam relative to the incoming optical axis by changing the relative position of the first and the second optical wedge.

The present invention may be applied in a beam steering device which combines a device for manipulation and routing of the metrology beam with a fixed mirror. Prior art beam bender manipulators that had less stability due to the fact that the bending action by the prior art beam bender manipulator occurred around a line which is substantially parallel to the adjustment axis of the manipulator. In the present invention, the beam steering device has an adjustment axis which is substantially perpendicular to the bending line, which by consequence yields a higher stability for the settings of the device.

Furthermore, the present invention provides a beam steering device which omits the fixed mirror and comprises only two optical wedges for manipulation and routing. In that case the stability of the settings is even improved further.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The person skilled in the art will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and " projection beam" are used to encompass all types of electromagnetic radiation, including ultraviolet (UV) radiation (e.g. with a wavelength of 365, 248, 193, 157 or 126 nm) and extreme ultra-violet (EUV) radiation (e.g. having a wavelength in the range 5-20 nm).

The metrology beam may comprise any type of electromagnetic radiation having a wavelength suitable for metrology purposes.

### Brief description of drawings

Below, the invention will be explained with reference to some drawings, which are intended for illustration purposes only and not to limit the scope of protection as defined in the accompanying claims.
Figure 1 depicts a lithographic projection apparatus;
Figure 2 schematically shows a device for manipulation and routing of a metrology beam according to an embodiment of the present invention and a first operation of the device;
Figure 3 schematically shows a second operation for manipulation of the metrology beam by the device according to an embodiment of the present invention;
Figure 4 schematically shows a third operation for manipulation of the metrology beam by the device according to an embodiment of the present invention;
Figure 5 schematically shows a fourth operation for manipulation of the metrology beam by the device according to an embodiment of the present invention;
Figures 6a and 6b schematically show an exemplary routing of a metrology beam to an interferometer according to a typical arrangement, and an embodiment of the present invention, respectively;
Figure 7 schematically shows a further embodiment of the device according to the present invention.

### Detailed description

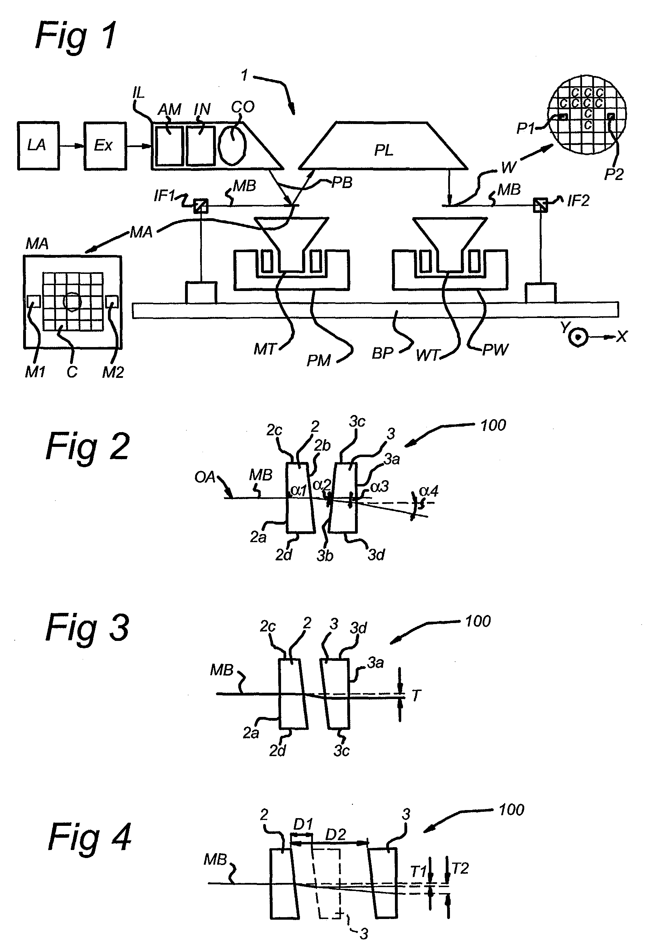

Figure 1 schematically depicts a lithographic projection apparatus 1 according to a particular embodiment of the invention. The apparatus comprises:
- a radiation system Ex, IL, for supplying a projection beam PB of radiation (e.g. UV radiation). In this particular case, the radiation system also comprises a radiation source LA;
- a first object table (mask table) MT provided with a mask holder for holding a mask MA (e.g. a reticle), and connected to first positioning means PM for accurately positioning the mask with respect to item PL;
- a second object table (substrate table) WT provided with a substrate holder for holding a substrate W (e.g. a resist-coated silicon wafer), and connected to second positioning means PW for accurately positioning the substrate with respect to item PL; and
- a projection system ("lens") PL for imaging an irradiated portion of the mask MA onto a target portion C (e.g. comprising one or more dies) of the substrate W.

As here depicted, the apparatus is of a reflective type (i.e. has a reflective mask). However, in general, it may also be of a transmissive type, for example (with a transmissive mask). Alternatively, the apparatus may employ another kind of patterning means, such as a programmable mirror array of a type as referred to above.

The source LA (e.g. a mercury lamp or an excimer laser) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and claims encompass both of these scenarios.

The beam PB subsequently intercepts the mask MA, which is held on a mask table MT. Having traversed the mask MA, the beam PB passes through the lens PL, which focuses the beam PB onto a target portion C of the substrate W. With the aid of the second positioning means PW and interferometric measuring means, the substrate table WT can be moved accurately, e.g. so as to position different target portions C in the path of the beam PB. Similarly, the first positioning means PM can be used to accurately position the mask MA with respect to the path of the beam PB, e.g. after mechanical retrieval of the mask MA from a mask library, or during a scan. In general, movement of the object tables MT, WT will be realised with the aid of a long-stroke module (coarse positioning) and a short-stroke module (fine positioning), which are not explicitly depicted in figure 1. However, in the case of a wafer stepper (as opposed to a step-and-scan apparatus) the mask table MT may just be connected to a short stroke actuator, or may be fixed. Mask MA and substrate W may be aligned using mask alignment marks M1, M2 and substrate alignment marks P1, P2.

The depicted apparatus can be used in two different modes:
1. In step mode, the mask table MT is kept essentially stationary, and an entire mask image is projected in one go (i.e. a single "flash") onto a target portion C. The substrate table WT is then shifted in the X and/or Y directions so that a different target portion C can be irradiated by the beam PB; and
2. In scan mode, essentially the same scenario applies, except that a given target portion C is not exposed in a single "flash". Instead, the mask table MT is movable in a given direction (the so-called "scan direction", e.g. the Y-direction) with a speed ν, so that the projection beam PB is caused to scan over a mask image; concurrently, the substrate table WT is simultaneously moved in the same or opposite direction at a speed V = M ν, in which M is the magnification of the lens PL (typically, M = 1/4 or 1/5). In this manner, a relatively large target portion C can be exposed, without having to compromise on resolution.

The interferometric measuring means typically can comprise a light source, such as a laser (not shown), and one or more interferometers for determining some information (e.g., position, alignment, etc.) regarding an object to be measured, such as a substrate or a stage. In Figure 1, for example, two interferometers IF1 and IF2 are schematically depicted. The light source (laser) produces a metrology beam MB which is routed to the interferometer(s) IF1, IF2 by one or more beam manipulators. In case more than one interferometer is present, the metrology beam is shared between them, by using optics that split the metrology beam in various separate beams for each interferometer. In Figure 1, for example, shows the metrology beam split into two beams. The splitter optics are not shown. A beam manipulator may also be used in the interferometer itself.

Figure 2 schematically shows a cross-section of a device for manipulation and routing of a metrology beam according to an embodiment of the present invention and a first operation of the device.

The device 100 for manipulation and routing of a metrology beam MB comprises first and second optical elements known as optical wedges 2, 3. Each of the first and second optical wedges 2, 3 comprises two minor surfaces 2c, 2d, and 3c, 3d, respectively. In each optical wedge, the two minor surfaces are substantially parallel, with 2d and 3d being the minor surface having a relatively larger area than the other minor surface 2c and 3c, respectively. Each of the optical wedges further comprise two major surfaces 2a, 2b and 3a, 3b, respectively. The major surfaces each extend from one minor surface to the other minor surface, with the two major surfaces not being parallel to each other. In the embodiment shown in Figure 2, the major surface 2a, 3a extends in a direction substantially perpendicular to the two minor surfaces 2c, 2d and 3c, 3d respectively. The other major surface 2b, 3b is slanted relative to the surfaces 2a, 2c, 2d, and 3a, 3c, 3d respectively. The device 100 further comprises an optical axis OA which is substantially perpendicular to the major surface 2a of the first optical wedge 2 and the major surface 3a of the second wedge 3.

It is noted that each of the optical wedges 2, 3 may be used with its respective major slanted surface 2b, 3b towards the incoming beam and the outgoing beam, respectively.

During operation, a metrology beam, such as a laser beam, travels in a direction substantially parallel to the optical axis OA, enters the first optical wedge 2 at major surface 2a, and is refracted at the major surface 2a over a first in-plane angle α1 relative to the optical axis OA of the incoming beam. Subsequently, the beam passes through the first wedge 2, exits at the slanted major surface 2b, and is again refracted over a second in-plane angle α2 relative to the optical axis OA of the incoming beam. Since in this case as an example the metrology beam MB enters the major surface 2a under substantially normal incidence, the first in-plane angle α1 is substantially equal to 0° to the optical axis OA. Next the metrology beam MB enters the slanted major surface 3b of the second optical wedge 3 and is again refracted over a third in-plane angle α3 relative to the optical axis OA of the incoming beam. Again refraction occurs while the beam passes the major surface 3a, and the metrology beam exits the second optical wedge 3 under a fourth in-plane angle α4 relative to the optical axis OA of the incoming beam.

In Figure 2, since all surfaces 2a, 2b and 3a, 3b are substantially perpendicular to the plane of the cross-section in Figure 2, the metrology beam exiting the second optical wedge is substantially parallel to that plane.

By changing the angular position of the second optical wedge 3 around the optical axis OA over an axial angle β (not shown), the orientation of the surfaces of the second optical wedge 3 can be changed in such a way that the surface 3b is not perpendicular to the plane of the cross-section in Figure 2. As a result, the optical path of the metrology beam comprises an angle in a direction out of the plane of the cross-section in Figure 2. Alternatively, the first optical wedge 2 may be rotated around the optical axis OA to result in the metrology beam comprising an angle in a direction out of the plane of the cross-section of Figure 2. In each of the cases of rotating the first optical wedge 2 or the second optical wedge 3, the other optical wedge - the second optical wedge 3 or the first optical wedge 2, respectively ― is not rotated. In another alternative, both the first optical wedge and the second optical wedge may be rotated to effect an angle for the metrology beam out of the plane of the cross-section of Figure 2.

The change of the angular position of an optical wedge around the optical axis OA is a first operation for the device 100.

Figure 3 schematically shows a special case of the first operation for manipulation of the metrology beam MB by the device according to an embodiment of the present invention.

A special case of the first operation occurs when the second optical wedge 3 is rotated over an axial angle β of 180° relative to the initial position as shown in Figure 2. When the geometry of the major surfaces of the first and second optical wedge 2, 3 is substantially identical, the relative positions as shown in Figure 3 result in an exiting metrology beam which is substantially parallel to the incoming beam, but translated over a distance T with respect to the optical axis OA. (The fourth in-plane angle α4 in this figure equals zero.) Alternatively, the first optical wedge 2 may be rotated over an axial angle β of 180° relative to the initial position as shown in Figure 2.

Figure 4 schematically shows a second operation for manipulation of the metrology beam MB by the device according to an embodiment of the present invention.

The second operation occurs when in case of the angular position of the first and second optical wedges 2, 3 as shown in Figure 3, a distance D between the first and second optical wedges 2, 3 is changed. As shown by the construction in the diagram of Figure 4 a shift of the lateral position (D2-D1) between the wedges 2, 3 changes the translation (T2-T1) of the metrology beam MB relative to the optical axis accordingly. A shorter distance between the optical wedges 2, 3 results in a smaller translation of the metrology beam relative to the optical axis OA, a larger distance in a larger translation.

A third operation occurs when the complete device i.e., the ensemble of the wedges 2, 3, is rotated around the optical axis OA, with the positions of the first and second optical wedges being fixed relative to each other (i.e., the device comprises a combination of a constant axial angle β for each wedge and a constant distance D between the wedges 2, 3). The exiting metrology beam having in-plane angle α4 is rotated around the optical axis OA, describing a circular path of projection around the optical axis OA. So, for example, a rotation of the complete device of 180° around the optical axis OA would result in the entire metrology beam having an in-plane angle of - α4 relative to the optical axis OA.

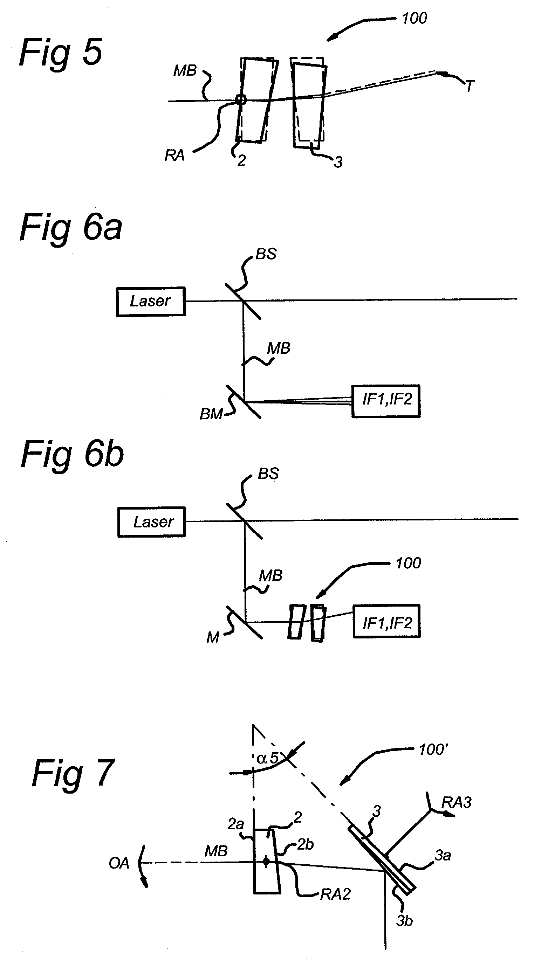

Figure 5 schematically shows a fourth operation for manipulation of the metrology beam by the device according to an embodiment of the present invention.

The fourth operation occurs when the device is rotated around a rotation axis perpendicular to the optical axis OA, with the positions of the first and second optical wedges 2, 3 being fixed relative to each other. The rotation axis is chosen perpendicular to the plane of the cross-section of Figure 2 (and Figure 5), as indicated by rotation axis symbol RA. In Figure 5 the device 100 is shown in an initial position drawn in dashed lines and in a second rotated position drawn by a continuous line. The initial optical path is shown also by a dashed line. The second optical path after rotation around the rotation axis RA is shown by a continuous line MB. As can be deduced from Figure 5 a rotation around axis RA results in a translation of the metrology beam parallel to the plane of the cross-section of Figure 2 (and Figure 5).

As will be appreciated by persons skilled in the art, various possible combinations of the first, second, third, and fourth operations allow angular and translational control over the position and direction of a metrology beam.

Additionally, because the first, second and third operations occur relative to the optical axis OA, a shift of the beam perpendicular to that direction has substantially no effect on the direction of the metrology beam MB as such. This contributes to a relatively higher stability of this device in comparison to devices from the prior art. Furthermore, since the fourth operation only changes the direction of the metrology beam in a plane parallel to the cross-section, this fourth operation does not introduce any misalignment of the metrology beam in a direction out of the cross-sectional plane. Therefore, the design of the disclosed device for manipulation and routing of a metrology beam is relatively stable, compact, and cost-effective.

It is noted that preferably the two optical wedges 2, 3 are a matched pair to reach a maximal manipulation range. If the optical wedges 2,3 are slightly different, an angle of zero degrees between incoming and outgoing beam may not be obtainable.

In the following figures some examples of beam manipulators for use in e.g., lithographic projection apparatus are shown that are based on the device as described above in Figures 2-5.

Figures 6a and 6b schematically show an exemplary routing of a metrology beam to an interferometer according to a typical embodiment, and according to an embodiment of the present invention, respectively.

In Figure 6a, a laser source generates a metrology beam MB which impinges on a fixed beam splitter BS. The fixed beam splitter BS splits the beam MB in a first portion for measurement by an interferometer detector IFM and a further portion for projection on an object to be measured such as a substrate or a stage. The first portion impinges on a beam bender manipulator BM for directing the first beam portion to the interferometer detector IFM. The beam bender manipulator BM typically comprises a rotatable mirror with a rotation axis perpendicular to the plane of the drawing. The rotating mirror is set in such a way to obtain an optimal signal on the interferometer detector IFM. Such a set-up procedure is well known in the art. As indicated schematically in Figure 6a by the three lines aimed at the interferometer detector IFM, the alignment of the beam is influenced by the stability of the setting of the beam manipulator BM.

In Figure 6b an alternative arrangement is shown which employs the device 100 for manipulating and routing of the metrology beam. In Figure 6b the same references indicate identical elements as shown in Figure 6a.

The beam manipulator BM is in this alternative arrangement replaced by the device 100 for manipulating and routing of the metrology beam, in combination with a fixed mirror M. After splitting at the beam splitter BS, a first portion of the beam MB impinges on the fixed mirror M and is reflected in the direction of device 100. After passing through the device 100 the first portion of the beam MB reaches the interferometer detector IFM. The device 100 can be set to manipulate the first portion of the beam MB by any combination of the four operations as described above with reference to Figures 2 to 5. In Figure 6b the fourth operation is illustrated schematically by a position drawn in a continuous line and a further position drawn in a dashed line.

The arrangement according to Figure 6b has a higher stability than in Figure 6a since the mirror M has a fixed position with a fixed alignment. Further, the design of device 100 offers a relatively high stability as already described above.

In Figure 6b the 'three component configuration' comprising a fixed mirror M and two optical wedges 2, 3 is shown. An alternative embodiment can be obtained wherein the fixed mirror M is omitted.

Figure 7 schematically shows a further embodiment of the device 100' according to the present invention.

The combination of a fixed mirror M and a device 100 for manipulating and routing of the metrology beam may be replaced by a single device 100' according to an embodiment of the present invention.

In this embodiment the first optical wedge 2 and the second optical wedge 3 are arranged to have an angle α5 between their respective major surfaces 2a and 3a. A metrology beam MB impinges under normal incidence on the slanted major surface 2b of the first optical wedge 2. Next, upon exiting the slanted major surface 2b, the beam refracts and impinges on the slanted major surface of the second optical wedge 3. Since the angle of incidence between the incoming beam and the slanted major surface of the second optical wedge 3 is smaller than the critical angle, the beam portion reflects on the slanted major surface 3b and is directed in a further direction. In this embodiment of the device 100', the first optical wedge 2 is adjustable by rotation around the optical axis OA and around a second rotation axis substantially perpendicular to the plane of the drawing, as indicated by axis symbol RA2. The second optical wedge 3 can be rotated around a third rotation axis RA3 which is substantially in the plane of the drawing and substantially normal to the major surface 3a of the second wedge 3.

The adjustment around the second rotation axis RA2 of the first optical wedge 2 is the operation most likely to cause a mechanical instability. Since the rotation axis RA2 is normal to the bending which occurs substantially in the plane of the drawing, stability regarding the setting of the beam direction is still guaranteed.

As will be appreciated by persons skilled in the art, the device 100' of this embodiment is capable of performing operations similar to the operations of the device 100 as described above with reference to the figures 2 to 5.

It is noted that the second optical wedge 3 may comprise a reflective coating on at least one of its major surfaces 3a, 3b to obtain reflection of the metrology beam at the slanted major surface 3b. In that case, the angle of incidence of the beam may be larger than the critical angle.

Persons skilled in the art will appreciate that other alternative and equivalent embodiments of the invention can be conceived and reduced to practice without departing form the true spirit of the invention, the scope of the invention being limited only by the appended claims.

## Claims

1. A lithographic projection apparatus (1) **characterised in that**
said apparatus comprises a device (100) for manipulation and routing of at least one portion of a metrology beam (MB) of radiation, said device (100) comprising a first (2) and a second optical wedge (3), said second optical wedge (3) and said first optical wedge (2) having a relative position with respect to each other, said at least one portion of said metrology beam (MB) entering said device (100) along an incoming optical axis (OA) at a first major surface (2a) of said first optical wedge (2), passing through said first (2) and second optical wedges (3), and exiting at a second major surface (3a) of said second optical wedge (3), said first and second optical wedges (2, 3) being arranged to at least one of rotate and translate said at least one portion of said metrology beam (MB) relative to said incoming optical axis (OA) by changing said relative position of said first and said second optical wedges (2, 3).

2. A lithographic projection apparatus according to claim 1, **characterised in that**
said device (100) is arranged to perform a first operation by rotating at least one of said first and second optical wedges (2, 3) over an axial angle (β) around said optical axis (OA).

3. A lithographic projection apparatus according to claim 1 or claim 2, **characterised in that**
said device (100) is arranged to perform a second operation by displacing at least one of said first and second optical wedges (2, 3) along said optical axis (OA) to change a distance (D) between them.

4. A lithographic projection apparatus according to any one of the claims 1 to 3, **characterised in that**
said device (100) is arranged to perform a third operation,
in which said first and second optical wedges (2, 3) have a fixed relative position with a fixed axial angle (β) and fixed distance (D), and
said first and second optical wedges (2, 3) are rotated as an ensemble around said optical axis (OA).

5. A lithographic projection apparatus according to any one of the claims 1 to 4, **characterised in that**
said device (100) is arranged to perform a fourth operation,
in which said first and second optical wedges (2, 3) have a fixed relative position with a fixed axial angle (β) and fixed distance (D), and
said first and second optical wedges (2, 3) are rotated as an ensemble around a rotating axis (RA) normal to said optical axis (OA).

6. A lithographic projection apparatus (1) **characterised in that**
said apparatus comprises a device (100') for manipulation and routing of at least one portion of a metrology beam (MB) of radiation,
said device (100') comprising a first (2) and a second optical wedge (3),
one of first and second major surfaces (3a, 3b) of said second optical wedge (3) being provided with a reflective coating,
said second optical wedge (3) and said first optical wedge (2) having a relative position with respect to each other,
said at least one portion of said metrology beam (MB) entering said device (100') along an incoming optical axis (OA) at a first major surface (2a) of said first optical wedge (2), passing through said first optical wedge(2), and reflecting at said one of said first and second major surfaces (3a, 3b) of said second optical wedge (3),
said first and second optical wedges (2, 3) being arranged to at least one of rotate and translate said at least one portion of said metrology beam (MB) relative to said incoming optical axis (OA) by changing said relative position of said first and said second optical wedges (2, 3).

7. A lithographic projection apparatus according to claim 6, **characterised in that**
said device (100') is arranged to rotate at least one of said first and second optical wedges (2, 3) over an axial angle (β) around said optical axis (OA).

8. A lithographic projection apparatus according to claim 6, **characterised in that**
said device (100') is arranged to rotate said second optical wedge (3) over an angle (β) around a rotation axis (RA3) substantially perpendicular to said first major surface (3a) of said second optical wedge (3).

9. A lithographic projection apparatus according to any one of the claims 6 to 8, **characterised in that**
said device (100') is arranged to displace at least one of said first and second optical wedges (2, 3) along said optical axis (OA) to change a distance (D) between them.

10. A lithographic projection apparatus according to any one of the claims 6 to 9, **characterised in that**
said first and second optical wedges (2, 3) have a fixed relative position with a fixed axial angle (β) and fixed distance (D), and
said device (100') is arranged to rotate said first and second optical wedges (2, 3) as an ensemble around said optical axis (OA).

11. A lithographic projection apparatus according to any one of the claims 6 to 10, **characterised in that**
said first and second optical wedges (2, 3) have a fixed relative position with a fixed axial angle (β) and fixed distance (D), and
said device (100') is arranged to rotate said first and second optical wedges (2, 3) as an ensemble around a rotating axis (RA2) normal to said optical axis (OA).

12. A device (100) for manipulation and routing of at least one portion of a metrology beam (MB) of radiation, **characterised in that**
said device (100) comprises a first (2) and a second optical wedge (3), said second optical wedge (3) and said first optical wedge (2) having a relative position with respect to each other, said at least one portion of said metrology beam (MB) entering said device (100) along an incoming optical axis (OA) at a first major surface (2a) of said first optical wedge (2), passing through said first optical wedge (2) and said second optical wedge (3), and exiting at a second major surface (3a) of said second optical wedge (3), said first and second optical wedges (2, 3) being arranged to at least one of rotate and translate said at least one portion of said metrology beam (MB) relative to said incoming optical axis (OA) by changing said relative position of said first and said second optical wedges (2, 3).

13. A device (100') for manipulation and routing of at least one portion of a metrology beam (MB) of radiation,
said device (100') comprising a first (2) and a second optical wedge (3),
one of first and second major surfaces (3a, 3b) of said second optical wedge (3) being provided with a reflective coating,
said second optical wedge (3) and said first optical wedge (2) having a relative position with respect to each other,
said at least one portion of said metrology beam (MB) entering said device (100') along an incoming optical axis (OA) at a first major surface (2a) of said first optical wedge (2), passing through said first optical wedge(2), and reflecting at said one of said first and second major surfaces (3a, 3b) of said second optical wedge (3),
said first and second optical wedges (2, 3) being arranged to at least one of rotate and translate said at least one portion of said metrology beam (MB) relative to said incoming optical axis (OA) by changing said relative position of said first and said second optical wedges (2, 3).

14. A device manufacturing method comprising the steps of:
- providing a metrology beam (MB) of radiation using a radiation system, **characterised by**
- entering at least one portion of said metrology beam (MB) along an incoming optical axis (OA) at a first major surface (2a) of a first optical wedge (2),
- passing said at least one portion of said metrology beam (MB) through said first optical wedge (2) and through a second optical wedge (3), said second optical wedge (3) and said first optical wedge (2) having a relative position with respect to each other,
- exiting said at least one portion of said metrology beam (MB) at a second major surface (3a) of said second optical wedge (3), and
- at least one of rotating and translating said at least one portion of said metrology beam (MB) relative to said incoming optical axis (OA) by changing said relative position of said first and said second optical wedges (2, 3).

15. A device manufacturing method comprising the steps of:
- providing a metrology beam (MB) of radiation using a radiation system, **characterised by**
- entering at least one portion of said metrology beam (MB) along an incoming optical axis (OA) at a first major surface (2a) of a first optical wedge (2),
- passing said at least one portion of said metrology beam (MB) through said first optical wedge (2),
- reflecting said at least one portion of said metrology beam (MB) at one of first and second major surfaces (3a, 3b) of said second optical wedge (3), said second optical wedge (3) and said first optical wedge (2) having a relative position with respect to each other, and
- at least one of rotating and translating said at least one portion of said metrology beam (MB) relative to said incoming optical axis (OA) by changing said relative position of said first and said second optical wedge (2, 3).
